Europäisches Patentamt

European Patent Office

Office européen des brevets

(19)

(11) EP 1 253 122 A1

## (12) EUROPEAN PATENT APPLICATION

(43) Date of publication:
**30.10.2002 Bulletin 2002/44**

(51) Int Cl.$^7$: **C04B 35/475**, H01L 41/187

(21) Application number: **01303756.9**

(22) Date of filing: **25.04.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **NGK Spark Plug Company Limited Nagoya, Aichi (JP)**

(72) Inventors:
 • **Takase, Masanori, NGK Spark Plug Co., Ltd. Nagoya, Aichi (JP)**
 • **Ohbayashi, Kazushige, Ngk Spark Plug Co., Ltd. Nagoya, Aichi (JP)**

(74) Representative: **West, Alan Harry et al**
 **R.G.C. Jenkins & Co.**
 **26 Caxton Street**
 **London SW1H 0RJ (GB)**

### (54) Piezoelectric ceramic material

(57) The invention seeks to provide a lead-free piezoelectric ceramic material having a high piezoelectric strain constant ($d_{33}$) and exhibiting excellent heat resistance, which material is suitable for producing knock sensor elements. This is achieved in the piezoelectric ceramic material of the invention which contains three components, BNT (bismuth sodium titanate, $(Bi_{0.5}Na_{0.5})TiO_3$), BT (barium titanate, $BaTiO_3$) and BKT (bismuth potassium titanate, $(Bi_{0.5}K_{0.5})TiO_3$), and preferably has a tetragonal perovskite-type crystal structure.

## Fig. 1

**Description**

The present invention relates to a piezoelectric ceramic material. More particularly, the present invention relates to a lead-free piezoelectric ceramic material which has a high piezoelectric strain constant and which exhibits high heat resistance. The piezoelectric ceramic material of the invention can be used for producing piezoelectric devices such as oscillators, actuators, sensors, and filters. More particularly, the piezoelectric ceramic material of the invention is suitable for producing knock sensor elements.

The majority of conventional piezoelectric ceramic materials contain lead, such as PT (lead titanate) and PZT (lead zirconate titanate). However, when such lead-containing piezoelectric ceramic materials are fired, evaporation of the lead-containing components, such as lead oxide, adversely affects the environment. Treatment of such lead-containing components to prevent such an adverse environmental effect involves high costs among other disadvantages. There has therefore been a strong need to develop lead-free piezoelectric ceramic materials.

$(Bi_{0.5}Na_{0.5})TiO_3$ (bismuth sodium titanate, "BNT") is a known lead-free piezoelectric ceramic material. Like PZT, BNT is a perovskite-type piezoelectric ceramic material and has a relatively high electromechanical coupling factor.

A variety of improved ceramic compositions containing BNT as a base substance have been studied. For example, Japanese Patent Publication (*kokoku*) No. 4-60073 describes a piezoelectric ceramic composition obtained by forming a solid solution, in BNT, of $BaTiO_3$ (barium titanate, "BT") or $(Bi_{0.5}K_{0.5})TiO_3$ (bismuth potassium titanate, "BKT"). Also Japanese Patent Application Laid-Open (*kokai*) No. 11-217262 describes a piezoelectric ceramic composition prepared by forming a solid solution, in BNT, of BKT and a transition metal oxide. Additionally, Japanese Patent Application Laid-Open (*kokai*) No. 9-100156 describes a piezoelectric ceramic composition prepared by forming a solid solution, in BNT, of $NaNbO_3$ (sodium niobate). Further, Japanese Patent Application Laid-Open (*kokai*) No. 11-60333 describes a perovskite-type solid solution ceramic material containing BNT as a component.

Piezoelectric ceramic materials are employed for producing knock sensors. Knock sensors are employed for detecting knocking of an engine and for the regulation of ignition timing. Most knock sensors used in the detection of engine vibration and pressure are produced from piezoelectric elements.

Piezoelectric elements employed for producing knock sensors must have a high piezoelectric strain constant in order to obtain a satisfactory level of sensitivity, and should suffer negligible thermal impairment when employed at high temperatures of 150°C. In order to satisfy these conditions, PT and PZT have conventionally been employed for producing such piezoelectric elements. However, in consideration of the aforementioned adverse environmental effect, there has been a demand for piezoelectric ceramic elements produced from lead-free piezoelectric materials such as BNT.

However, the piezoelectric strain constant ($d_{33}$) of BNT is as small as 70 pC/N, as compared with the $d_{33}$ of PZT of 300 pC/N. Moreover, the piezoelectric characteristics of BNT start to deteriorate at about 150°C or higher and this deterioration is attributed to the transformation of BNT into an antiferroelectric phase. Therefore, using BNT in the production of knock sensor elements is difficult.

The present invention seeks to provide a lead-free piezoelectric ceramic material having a high piezoelectric strain constant ($d_{33}$) and exhibiting high heat resistance, the material being suitable for producing a knock sensor element.

The present invention is based on the surprising observation that a piezoelectric ceramic material containing three components, BNT, BT, and BKT, has a high piezoelectric strain constant ($d_{33}$) and exhibits high heat resistance.

According to the present invention, there is provided a lead-free piezoelectric ceramic material having a piezoelectric strain constant ($d_{33}$) of 100 pC/N or more. The percent reduction ($D_{d33}$) in the piezoelectric strain constant ($d_{33}$) of the piezoelectric ceramic material is 15% (absolute value) or less when subjected to a high-temperature test in which a sample is held at 150°C for 72 hours.

The invention provides a piezoelectric ceramic material containing three components, BNT, BT and BKT. BNT, BT and BKT are ferroelectric materials, but BNT differs from BT and BKT in that BNT has a rhombohedral perovskite structure whereas BT and BKT both have tetragonal perovskite structures. The piezoelectric ceramic material of the invention is a solid solution containing these three components as essential components. Similar to the case of PZT, the ceramic material of the present invention also contains an MPB (morphotropic phase boundary).

A characteristic feature of the invention resides in that the piezoelectric ceramic material comprises $(Bi_{0.5}Na_{0.5})TiO_3$, $BaTiO_3$, and $(Bi_{0.5}K_{0.5})TiO_3$. This material has a high piezoelectric strain constant ($d_{33}$) and exhibits high heat resistance as a result not only of combining a rhombohedral perovskite structure compound (BNT) with a tetragonal perovskite structure compound, but also by utilizing two tetragonal perovskite structure compounds (BT and BKT in combination with BNT. The piezoelectric ceramic material exhibits excellent heat resistance, i.e. the percent reduction ($D_{d33}$) in the piezoelectric strain constant ($d_{33}$) of the piezoelectric ceramic material is 15% (absolute value) or less when subjected to a high-temperature test in which a sample is held at 150°C for 72 hours, which is a typical test for evaluating the heat resistance of a knock sensor element, and is referred to below simply as "excellent heat resistance as specified above". The value of $D_{d33}$ is calculated on the basis of the following formula 1.

$$D_{d33} \text{ (%)} = 100 \times (d_{33} \text{ after test} - d_{33} \text{ before test})/(d_{33} \text{ before test}) \qquad \text{(formula 1)}$$

The piezoelectric ceramic material of the invention as described above is suitable for producing knock sensor elements.

When the proportion of BNT is lower (i.e., the compositional proportions of the tetragonal perovskite structure compounds are higher ), the heat resistance of the piezoelectric ceramic material of the invention may be drastically higher. This enhancement of the heat resistance is a specific effect which is obtained by specifying two tetragonal perovskite structure compounds (BT and BKT) which are employed in combination with BNT. The reason for this enhancement of the heat resistance is thought to be that when such specific tetragonal perovskite structure compounds are employed in combination with BNT, the temperature at which the piezoelectric ceramic material is transformed into an antiferroelectric phase increases, or the piezoelectric ceramic material is not transformed into an antiferroelectric phase.

The piezoelectric ceramic material of the invention comprises a tetragonal perovskite-type crystal structure. When BNT having a rhombohedral perovskite-type crystal structure is combined with BT-BKT having a tetragonal perovskite-type crystal structure so as to form a solid solution predominantly having a tetragonal perovskite-type crystal structure, there is produced a piezoelectric ceramic material having a higher piezoelectric strain constant ($d_{33}$) and exhibiting higher heat resistance (i.e., transformation into an antiferroelectric phase does not occur at high temperature). The piezoelectric ceramic material then exhibits excellent heat resistance as specified above. Such a piezoelectric ceramic material according to the invention is more suitable for producing knock sensor elements.

The piezoelectric ceramic material of the invention may contain a characteristic-regulating aid, to thereby regulate its characteristics. The characteristic-regulating aid is preferably a transition metal compound, more preferably a transition metal oxide. Preferred examples of transition metal oxides include $Mn_2O_3$, $MnO_2$, $Co_2O_3$, $Fe_2O_3$, NiO and $Cr_2O_3$. The transition metal oxide is more preferably $Mn_2O_3$ or $MnO_2$.

The piezoelectric ceramic material of the invention does not necessarily have a single-crystal structure of the tetragonal perovskite type. The piezoelectric ceramic material may contain, in addition to a tetragonal perovskite-type crystal structure, other crystal structures attributed to the aforementioned characteristic-regulating aids, so long as the crystal structures do not adversely affect the piezoelectric strain constant ($d_{33}$) and the heat resistance of the piezoelectric ceramic material.

The piezoelectric ceramic material of the invention may comprise a crystal structure of the tetragonal perovskite type. When BNT having a rhombohedral perovskite-type crystal structure is combined with BT-BKT having a tetragonal perovskite-type crystal structure so as to form a solid solution whose crystal structure is of the tetragonal perovskite type, there is produced a piezoelectric ceramic material having a higher piezoelectric strain constant ($d_{33}$) and exhibiting higher heat resistance.

The piezoelectric ceramic material according to the invention suitably has a single-crystal structure of the tetragonal perovskite type, and thus, particularly, the heat resistance of the ceramic material is enhanced. The piezoelectric ceramic material exhibits excellent heat resistance as specified above. Therefore, the piezoelectric ceramic material of the invention is particularly suitable for producing knock sensor elements.

The invention is described below in greater detail by way of example only with reference to the accompanying drawings, in which:

Fig. 1 is a ternary diagram showing a preferred range of composition according to the invention;
Fig. 2 is a ternary diagram showing a more preferred range of composition according to the invention;
Fig. 3 is an enlarged view of the ternary diagrams of Figs. 1 and 2;
Fig. 4 is an X-ray diffraction spectrum of the sample corresponding to point I of the ternary diagram of Fig. 3; and
Fig. 5 is an X-ray diffraction spectrum of the sample corresponding to point F of the ternary diagram of Fig. 3.

Preferably, the piezoelectric ceramic material of the invention has a composition represented by the formula xBNT-yBT-zBKT, such that the values of x, y, and z are contained in the region of the BNT-BT-BKT ternary diagram formed by connecting points A, E, F, B, C, I, J, and D (including the values between points E and F and between points I and J, but excluding the values between other successive points), in which A is (0.5, 0, 0.5), E is (0.6, 0, 0.4), F is (0.7, 0, 0.3), B is (0.8, 0, 0.2), C is (0.9, 0.1, 0), I is (0.8, 0.2, 0), J is (0.6, 0.4, 0) and D is (0.5, 0.5, 0).

Such a material has excellent heat resistance as specified above and preferably has a piezoelectric strain constant ($d_{33}$) of more than 100 pC/N, or $D_{d33}$ of less than 15%.

When the compositional proportions of BNT, BT, and BKT fall within the region formed by connecting the points A, E, F, B, C, I, J, and D in the ternary diagram of BNT-BT-BKT (the region contains a segment between points E and F and a segment between points I and J, but other sides are excluded), the piezoelectric ceramic material has a piezoelectric strain constant ($d_{33}$) of 100 pC/N or more and excellent heat resistance as specified above.

The piezoelectric ceramic material of the invention as described above is suitable for producing knock sensor elements. In contrast, when the compositional proportions of BNT, BT, and BKT fall outside the above region, the piezoelectric strain constant ($d_{33}$) or heat resistance of the resultant piezoelectric ceramic material is lowered, and thus the ceramic material cannot be used in practice for producing knock sensor elements.

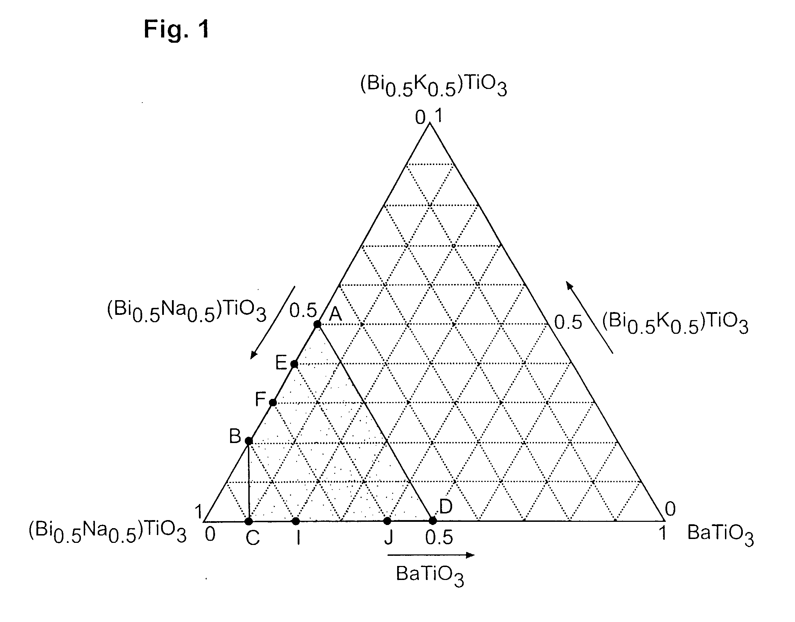

The MPB is in the vicinity of the segment between points B and C as shown in Fig. 1 of the accompanying drawings (in a region in which the proportion of BNT is high). The piezoelectric characteristics of a piezoelectric ceramic material are greatly enhanced in the vicinity of the MPB, and thus a high piezoelectric strain constant ($d_{33}$) can be obtained. At points B and C in the vicinity of the MPB, the piezoelectric ceramic material has an especially high piezoelectric strain constant ($d_{33}$) of more than 150 pC/N.

In that region in which the compositional proportion of BNT is higher than that of BNT in the vicinity of the segment between points B and C, the piezoelectric ceramic material has a rhombohedral perovskite structure. In contrast, in that region in which the compositional proportion of BNT is lower than that of BNT in the vicinity of the segment between the points B and C, the piezoelectric ceramic material has a tetragonal perovskite structure. A piezoelectric ceramic material which exhibits excellent heat resistance and is suitable for producing a knock sensor element therefore preferably has a predominantly tetragonal perovskite structure. This piezoelectric ceramic material has a high piezoelectric strain constant ($d_{33}$), and excellent heat resistance as specified above.

More preferably, the piezoelectric ceramic material of the invention has a composition represented by the formula xBNT-yBT-zBKT, such that the values of x, y, and z are contained in the region of the BNT-BT-BKT ternary diagram formed by connecting points E, F, G, H, I, and J (including the values between the points) in which E is (0.6, 0, 0.4), F is (0.7, 0, 0.3), G is (0.8, 0.05, 0.15). H is (0.85, 0.1, 0.05), I is (0.8, 0.2, 0), and J is (0.6, 0.4, 0). When the compositional proportions of BNT, BT and BKT fall within this preferred region, the piezoelectric ceramic material which is very suitable for producing knock sensor elements. The piezoelectric ceramic material then has a piezoelectric strain constant ($d_{33}$) of 100 pC/N or more, and the percent reduction ($D_{d33}$) in the piezoelectric strain constant ($d_{33}$) of the piezoelectric ceramic material is 10% (absolute value) or less when subjected to a high-temperature test in which a sample is held at 150°C for 72 hours.

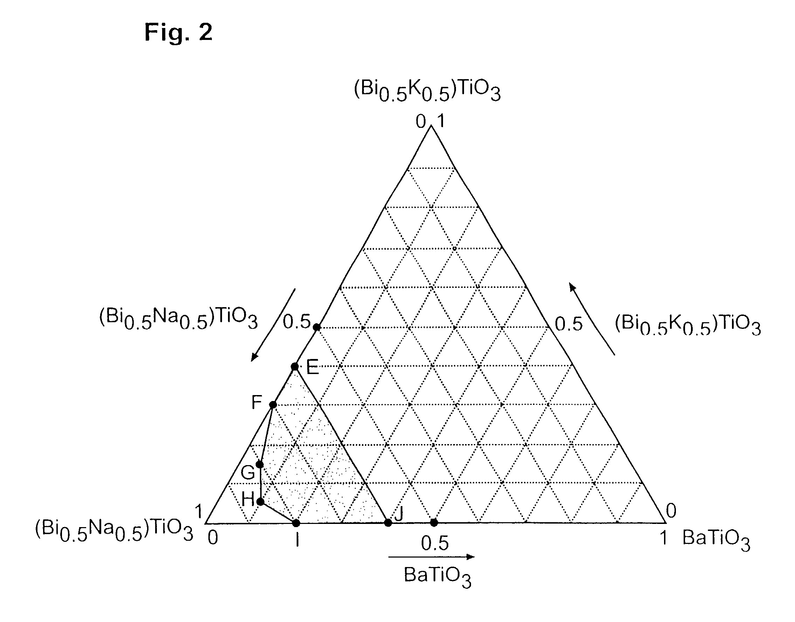

When the compositional proportion of BNT is smaller than that of BNT at point B or C shown in FIG. 1 in the vicinity of the MPB (i.e., when the compositional proportions of BT and BKT are higher), the piezoelectric strain constant ($d_{33}$) of the piezoelectric ceramic material is gradually reduced. When the compositional proportions of BNT, BT, and BKT are within the region formed by connecting points E, F, G, H, I, and J shown in Fig. 2 (the region contains segments between the points), the piezoelectric ceramic material has a piezoelectric strain constant ($d_{33}$) of 100 pC/N or more, and thus the ceramic material can be practically employed in the production of knock sensor elements. The piezoelectric ceramic material corresponding to point A or point D in Fig. 1 has a piezoelectric strain constant ($d_{33}$) nearly equal to the above value.

As described above, the heat resistance of a piezoelectric ceramic material is related to transformation of the material into an antiferroelectric phase at high temperature. In the vicinity of the MPB, the transformation temperature of a piezoelectric ceramic material temporarily decreases, and thus the heat resistance thereof also decreases. In contrast, in the region in which the compositional proportion of BNT is smaller than that in the vicinity of the MPB, in which the piezoelectric ceramic material has a tetragonal structure, the heat resistance of the ceramic material drastically increases. The reason for this is thought to be that the temperature at which the piezoelectric ceramic material is transformed into an antiferroelectric phase increases, or the piezoelectric ceramic material is not transformed into an antiferroelectric phase.

The percent reduction ($D_{d33}$) in the piezoelectric strain constant ($d_{33}$) of the piezoelectric ceramic material corresponding to point B or point C in Fig. 1 in the vicinity of the MPB is about -50%. In contrast, the percent reduction ($D_{d33}$) in the piezoelectric strain constant ($d_{33}$) of piezoelectric ceramic materials corresponding to points F, G, H, and I is -10 to -5%; i.e., the percent reduction ($D_{d33}$) drastically decreases. Piezoelectric ceramic materials corresponding to points A and D also exhibit excellent heat resistance; i.e., the percent reduction ($D_{d33}$) in the piezoelectric strain constant ($d_{33}$) of the piezoelectric ceramic materials is -15 to 0%.

The following Examples illustrate the invention.

Examples

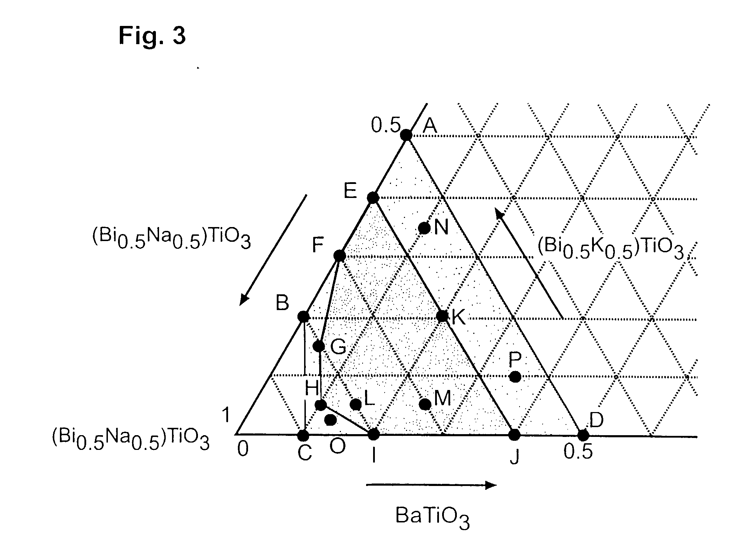

BaCO$_3$ powder, Bi$_2$O$_3$ powder, K$_2$CO$_3$ powder, Na$_2$CO$_3$ powder and TiO$_2$ powder, serving as starting materials, are weighed so as to attain the compositional proportions shown in Table 1 (or shown in the ternary diagram in Fig. 3 of the accompanying drawings). These powders and ethanol are placed in a ball mill, and then wet-mixed for 15 hours.

The resultant mixture is dried in a hot-water bath, and then calcined at 800°C for two hours. Subsequently, the calcined product, an organic binder, and ethanol are placed in a ball mill, and then wet-ground for 15 hours. Subsequently, the resultant ground product is dried in a hot water bath to thereby form granules, and the granules are shaped into a product having a diameter of 20 mm and a thickness of 3 mm through uniaxial pressing at 1 GPa. Thereafter, the shaped product is subjected to cold isostatic pressing (CIP) at 15 GPa.

The shaped product which has undergone CIP is fired at 1,050-1,250°C for two hours, to thereby produce a sintered product. The upper and lower surfaces of the resultant fired product are subjected to polishing, to thereby form a disk. Subsequently, a silver paste is applied to both surfaces of the disk, and baking is carried out, to thereby form a disk-shaped element. Thereafter, the element is subjected to polarization treatment in insulating oil maintained at 10-200°C, through application of a direct current of 3-7 kV/mm for 30 minutes. After completion of the polarization treatment, the element is cut into pieces, to thereby produce a square pillar-shaped sample to allow measurement of the piezoelectric characteristics.

The piezoelectric strain constant ($d_{33}$) of the sample is measured through a resonance-antiresonance method by use of an impedance analyzer (model: HP4194A, Hewlett Packard). Thereafter, the sample is subjected to a high-temperature test; i.e., the sample is allowed to stand at 150°C for 72 hours, to thereby obtain $D_{d33}$, which is the percentage difference between the piezoelectric strain constant ($d_{33}$) before the test and that after the test. The results are shown in Table 1.

Table 1

| Sample No. | Point | | | | $d_{33}$ (pC/N) | $D_{d33}$ (%) |
|---|---|---|---|---|---|---|
| | (Fig.3) | x | y | z | | |
| 1 | A | 0.5 | 0 | 0.5 | 96 | -15 |
| 2 | B | 0.8 | 0 | 0.2 | 158 | -55 |
| 3 | C | 0.9 | 0.1 | 0 | 151 | -53 |
| 4 | D | 0.5 | 0.5 | 0 | 93 | -15 |
| 5 | E | 0.6 | 0 | 0.4 | 102 | -10 |
| 6 | F | 0.7 | 0 | 0.3 | 113 | -10 |
| 7 | G | 0.8 | 0.05 | 0.15 | 127 | -8 |
| 8 | H | 0.85 | 0.1 | 0.05 | 134 | -6 |
| 9 | I | 0.8 | 0.2 | 0 | 121 | -5 |
| 10 | J | 0.6 | 0.4 | 0 | 104 | -9 |
| 11 | K | 0.6 | 0.2 | 0.2 | 105 | -9 |
| 12 | L | 0.8 | 0.15 | 0.05 | 120 | -5 |
| 13 | M | 0.7 | 0.25 | 0.05 | 104 | -7 |
| 14 | N | 0.55 | 0.1 | 0.35 | 101 | -12 |
| 15 | O | 0.85 | 0.125 | 0.025 | 129 | -15 |
| 16 | P | 0.55 | 0.35 | 0.1 | 103 | -12 |

As is apparent from Table 1, in the samples having compositions corresponding to points E to P according to the invention, the piezoelectric strain constant ($d_{33}$) is 101 to 134 pC/N and the percent reduction ($D_{d33}$) is -5 to -15%, which are favourable. In addition, the results reveal that, in the samples having compositions corresponding to points E to M according to the invention, the piezoelectric strain constant ($d_{33}$) is 102 to 134 pC/N and the percent reduction ($D_{d33}$) is -5 to -10%, which are more favourable.

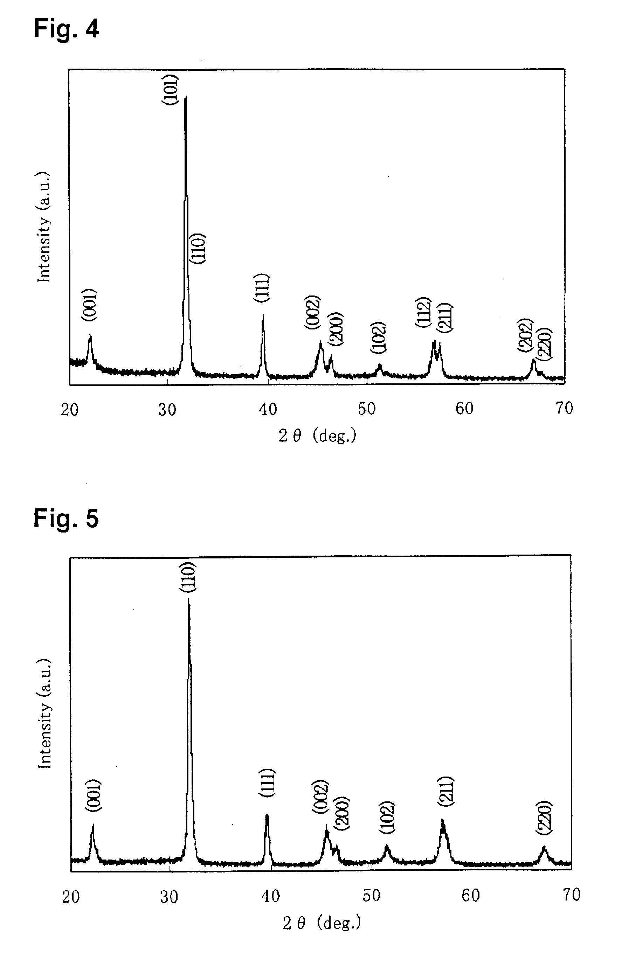

The crystal phase of each sample is identified as a tetragonal perovskite-type crystal structure through X-ray diffraction. For example, Figs. 4 and 5 of the accompanying drawings show X-ray diffraction data of the samples having compositions corresponding to point I and point F, respectively. The data reveal that these samples have a tetragonal perovskite-type crystal structure, since there appear two separate peaks at (002) and (200) in the vicinity of 2θ = 45 deg, while a rhombohedral structure shows a peak overlapping the (002) and (200) peaks.

The samples having compositions corresponding to points A, B, C, and D, which points fall within the broad scope of the present invention but beyond the scope of the preferred aspects of the invention have a tetragonal perovskite structure. However, the piezoelectric strain constant ($d_{33}$) of these samples is less than 100 pC/N, the percent reduction ($D_{d33}$) is in excess of 15% (absolute value) (i.e., lower than -15%). Therefore, such a sample is not of practical use for producing, in particular, knock sensor elements.

The piezoelectric ceramic material of the present invention is not limited to those mentioned in the above Examples, and may have any composition so long as there is no deviation from the spirit of the present invention. If necessary, the piezoelectric ceramic material may contain a trace amount of an aid such as manganese oxide. The piezoelectric ceramic material does not necessarily have a single-crystal phase of tetragonal perovskite-type and may contain other crystal phases, so long as the crystal phases do not adversely affect its piezoelectric characteristics.

According to the present invention, a lead-free piezoelectric ceramic material can be produced having a high piezoelectric strain constant (i.e., $d_{33}$ is 100 pC/N or more) and exhibiting high heat resistance (i.e., the percent reduction in $d_{33}$ is 15% (absolute value) or less, or 10% (absolute value) or less, in a high-temperature test in which a sample is held at 150°C for 72 hours). The piezoelectric ceramic material of the present invention can be used for producing piezoelectric devices such as oscillators, actuators, sensors and filters. Particularly, the piezoelectric ceramic material is suitable for producing knock sensor elements.

## Claims

1. A piezoelectric ceramic material comprising $(Bi_{0.5}Na_{0.5})TiO_3$, $BaTiO_3$, and $(Bi_{0.5}K_{0.5})TiO_3$.

2. A piezoelectric ceramic material according to claim 1, comprising a tetragonal perovskite-type crystal structure.

3. A piezoelectric ceramic material according to claim 1, having a tetragonal perovskite-type crystal structure.

4. A piezoelectric ceramic material according to any one of claims 1 to 3, having a composition represented by the formula xBNT-yBT-zBKT, such that the values of x, y, and z are contained in the region of the BNT-BT-BKT ternary diagram formed by connecting points A, E, F, B, C, I, J, and D (including the values between points E and F and between points I and J, but excluding the values between other successive points), in which A is (0.5, 0, 0.5), E is (0.6, 0, 0.4), F is (0.7, 0, 0.3), B is (0.8, 0, 0.2), C is (0.9, 0.1, 0), I is (0.8, 0.2, 0), J is (0.6, 0.4, 0) and D is (0.5, 0.5, 0).

5. A piezoelectric ceramic material according to any one of claims 1 to 4, having a composition represented by the formula xBNT-yBT-zBKT, such that the values of x, y and z are contained in the region of the BNT-BT-BKT ternary diagram formed by connecting points E, F, G, H, I, and J (including the values between the points) in which E is (0.6, 0, 0.4), F is (0.7, 0, 0.3), G is (0.8, 0.05, 0.15), H is (0.85, 0.1, 0.05), I is (0.8, 0.2, 0), and J is (0.6, 0.4, 0).

**Fig. 1**

**Fig. 2**

$(Bi_{0.5}K_{0.5})TiO_3$

$(Bi_{0.5}Na_{0.5})TiO_3$

$(Bi_{0.5}K_{0.5})TiO_3$

$(Bi_{0.5}Na_{0.5})TiO_3$

$BaTiO_3$

$BaTiO_3$

EP 1 253 122 A1

8

**Fig. 3**

$(Bi_{0.5}Na_{0.5})TiO_3$

$(Bi_{0.5}K_{0.5})TiO_3$

$(Bi_{0.5}Na_{0.5})TiO_3$

$BaTiO_3$

## Fig. 4

## Fig. 5

**European Patent Office**

# EUROPEAN SEARCH REPORT

Application Number

EP 01 30 3756

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | CHIANG Y-M ET AL: "LEAD-FREE HIGH-STRAIN SINGLE-CRYSTAL PIEZOELECTRICS IN THE ALKALINE-BISMUTH-TITANATE PEROVSKITE FAMILY" APPLIED PHYSICS LETTERS, AMERICAN INSTITUTE OF PHYSICS. NEW YORK, US, vol. 73, no. 25, 21 December 1998 (1998-12-21), pages 3683-3685, XP000805669 ISSN: 0003-6951 * page 3683, column 2, line 3-6 * * page 3683, column 2, line 21-25 * * page 3684, column 1, line 24 – line 33 * | 1-3 | C04B35/475 H01L41/187 |
| X | DATABASE CA 'Online! CHEMICAL ABSTRACTS SERVICE, COLUMBUS, OHIO, US; FARREY, G. W. ET AL: "Growth and characterization of Na1/2Bi1/2TiO3-K1/2Bi1/2TiO3-BaTiO3 single-crystal piezoelectrics" retrieved from STN Database accession no. 131:280038 XP002185038 * abstract * & PROC. IEEE INT. SYMP. APPL. FERROELECTR., 11TH (1998), 551-554. EDITOR(S): COLLA, ENRICO;DAMJANOVIC, DRAGAN; SETTER, NAVA. PUBLISHER: INSTITUTE OF ELECTRICAL AND ELECTRONICS ENGINEERS, NEW YORK, N. Y. , <br><br>* the whole document * <br><br>-/-- | 1-5 | **TECHNICAL FIELDS SEARCHED** (Int.Cl.7) <br> C04B <br> H01L |

The present search report has been drawn up for all claims

| Place of search | Date of completion of the search | Examiner |
|---|---|---|
| MUNICH | 7 December 2001 | Wirth, S |

CATEGORY OF CITED DOCUMENTS

X : particularly relevant if taken alone
Y : particularly relevant if combined with another
    document of the same category
A : technological background
O : non–written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

European Patent
Office

## EUROPEAN SEARCH REPORT

Application Number

EP 01 30 3756

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | TADASHI TAKENAKA ET AL: "(BI1/2NA1/2)TIO3-BATIO3 SYSTEM FOR LEAD-FREE PIEZOELECTRIC CERAMICS" JAPANESE JOURNAL OF APPLIED PHYSICS, PUBLICATION OFFICE JAPANESE JOURNAL OF APPLIED PHYSICS. TOKYO, JP, vol. 30, no. 9B, 1 September 1991 (1991-09-01), pages 2236-2239, XP000269862 ISSN: 0021-4922 * figure 4 * | 4,5 | |
| X | JP 11 217262 A (TOKIN CORP) 10 August 1999 (1999-08-10) Page 3, table 1, composition nr.8 | 4,5 | |
| E | PATENT ABSTRACTS OF JAPAN vol. 2000, no. 23, 10 February 2001 (2001-02-10) & JP 2001 151566 A (NGK SPARK PLUG CO LTD), 5 June 2001 (2001-06-05) * abstract * | 1-5 | TECHNICAL FIELDS SEARCHED (Int.Cl.7) |

The present search report has been drawn up for all claims

| Place of search | Date of completion of the search | Examiner |
|---|---|---|
| MUNICH | 7 December 2001 | Wirth, S |

## ANNEX TO THE EUROPEAN SEARCH REPORT
## ON EUROPEAN PATENT APPLICATION NO.

EP 01 30 3756

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2001

| Patent document cited in search report | | Publication date | Patent family member(s) | Publication date |
|---|---|---|---|---|
| JP 11217262 | A | 10-08-1999 | NONE | |
| JP 2001151566 | A | 05-06-2001 | NONE | |

EPO FORM P0459

For more details about this annex : see Official Journal of the European Patent Office, No. 12/82